(19) Europäisches Patentamt
European Patent Office
Office européen des brevets

(11)  EP 4 372 143 A1

(12)  EUROPEAN PATENT APPLICATION
published in accordance with Art. 153(4) EPC

(43) Date of publication:
     22.05.2024 Bulletin 2024/21

(51) International Patent Classification (IPC):
     D06M 11/83 (2006.01)      C23C 14/34 (2006.01)

(21) Application number: 22822252.7

(22) Date of filing: 30.09.2022

(86) International application number:
     PCT/KR2022/014752

(87) International publication number:
     WO 2024/071484 (04.04.2024 Gazette 2024/14)

(84) Designated Contracting States:
     AL AT BE BG CH CY CZ DE DK EE ES FI FR GB
     GR HR HU IE IS IT LI LT LU LV MC MK MT NL NO
     PL PT RO RS SE SI SK SM TR
     Designated Extension States:
     BA ME
     Designated Validation States:
     KH MA MD TN

(30) Priority: 27.09.2022 KR 20220122664

(71) Applicant: HSN Company Ltd.
     Daegu 41706 (KR)

(72) Inventor: LEE, Jun Ho
     Suseong-gu Daegu 42170 (KR)

(74) Representative: Ter Meer Steinmeister & Partner
     Patentanwälte mbB
     Nymphenburger Straße 4
     80335 München (DE)

(54)  **METHOD FOR MANUFACTURING ANTIVIRAL FABRIC, AND ANTIVIRAL FABRIC MANUFACTURED THEREBY**

(57)   The present disclosure relates to a method of manufacturing an antiviral fabric and an antiviral fabric manufactured thereby. The method comprises pre-processing a fabric and forming a metal layer by plasma sputtering on one or both sides of the fabric, in which the metal layer has a thickness in a range of 5 nm to 900 nm.

Fig. 1

EP 4 372 143 A1

## Description

### Technical Field

The present disclosure claims priority to Korean Patent Application No. 10-2022-0122664, filed with the Korean Intellectual Property Office on September 27, 2022, the entire contents of which are incorporated herein for all purposes by reference.

The present disclosure relates to a method of manufacturing an antiviral fabric and an antiviral fabric manufactured thereby.

### Background Art

Viruses are infectious agents and are intermediates between living and non-living things. A virus requires a host for parasitism and proliferation thereof and consists of two or three parts that protect the genetic material consisting of DNA or RNA.

The virus has a very simple structure consisting of a genetic material such as RNA or DNA and a protein coat (called capsid) surrounding the genetic material. The protein coat (capsid) is a collection of beaded proteins (capsomeres). Some viruses have a membrane consisting of lipids in addition to the protein coat.

Cloth or fabrics, which are closely related to human life, are easy for viruses to penetrate and thus function as virus carriers. To impart antimicrobial functions to a fabric, techniques of adding antimicrobial substances to the fabric are being developed. However, existing techniques have problems in that antiviral substances are expensive, a large amount of antiviral substance is required, and antiviral substances have poor adhesion to fabrics.

[Documents of Related Art]

[Patent Document]

KR 10-1724038 B1

### Disclosure

### Technical Problem

The present disclosure relates to a method of manufacturing an antiviral fabric and an antiviral fabric manufactured thereby.

### Technical Solution

One embodiment of the present disclosure provides a method of manufacturing an antiviral fabric, the method comprising:

pre-processing a fabric; and forming a metal layer on one surface or both surfaces of the fabric through plasma sputtering,
in which the metal layer has a thickness in a range of 5 nm to 900 nm.

One embodiment of the present disclosure provides an antiviral fabric prepared by the method, the antiviral fabric comprising:
a fabric; and a metal layer having a thickness in a range of 5 nm to 900 nm and being provided on one surface or both surfaces of the fabric.

### Advantageous Effects

With the use of the antiviral fabric manufacturing method according to one embodiment of the present disclosure, it is possible to manufacture a fabric having excellent antiviral properties.

### Description of Drawings

FIG. 1 is a diagram illustrating an antiviral fabric according to one embodiment of the present disclosure.
FIG. 2 illustrates a process in which a metal layer of the antiviral fabric kills viruses.
FIG. 3 illustrates photographs of a surface of a fabric before or after plasma sputtering.
FIG. 4 illustrates the results of Experimental Example 1.
FIG. 5 is a test report for an antiviral fabric of Example 4.

**Best Mode**

Hereinafter, the present disclosure will be described in detail.

As used herein, the term "antiviral function" or "antiviral" refers to an antibacterial function, a virus killing function, or a combination thereof.

One embodiment of the present disclosure provides a method of manufacturing an antiviral fabric, the method comprising: pre-processing a fabric; and

forming a metal layer on one surface or both surfaces of the fabric through plasma sputtering,
in which the metal layer has a thickness in a range of 5 nm to 900 nm.

The manufacturing method provides excellent adhesion between a fabric and a metal layer. When the metal layer has an antiviral function, the antiviral function can be imparted to a fabric.

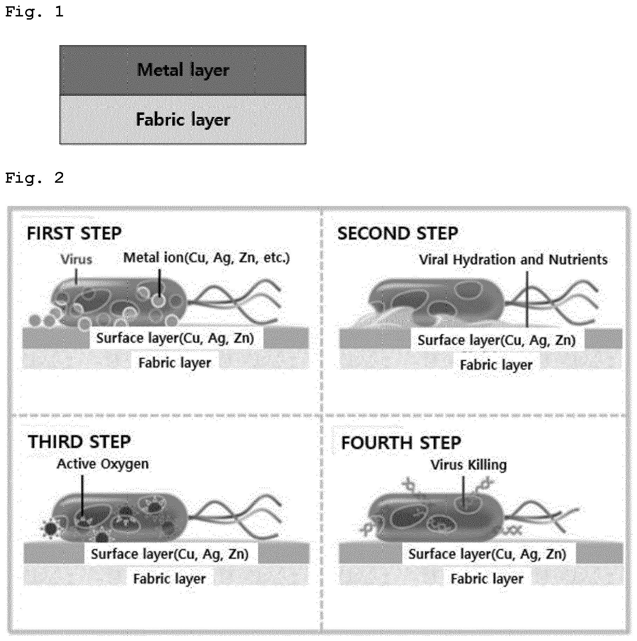

In one embodiment of the present disclosure, the metal layer serves to impart an antiviral function to a fabric. Specifically, viruses approach metal ions in the metal layer (step 1 in FIG. 2) by recognizing the metal ions as hosts. The metal ions destroy the shell of the virus (step 2 in FIG. 2) and permeates into the virus through the shell (step 3 in FIG. 2). In this stage, the metabolism of the virus is stopped, and DNA and RNA of the virus decompose, resulting in death of the virus (step 4 in FIG. 2).

In one embodiment of the present disclosure, the metal layer may have a thickness in a range of 5 nm to 900 nm, a range of 5 nm to 500 nm, a range of 5 nm to 200 nm, a range of 5 nm to 100 nm, or a range of 8 nm to 20 nm. The metal layer has an antiviral function. However, when the metal layer is excessively thick, the physical properties of the fabric deteriorate. When the thickness of the metal layer falls within the numerical range described above, the antiviral function of the metal layer is maintained, and the physical properties of the fabric are maintained.

In one example of the present disclosure, the antiviral fabric manufacturing method satisfies Formula 1 shown below.

$$[Formula\ 1]$$

$$T1/T0\ *\ 100\ (\%)\ \geq\ 70$$

In Formula 1,

T1 is the tensile strength T1 of the antiviral fabric after forming the metal layer by plasma sputtering on one or both surfaces of the fabric, and
T0 is the tensile strength T0 of the antiviral fabric prior to forming the metal layer by plasma sputtering on one or both surfaces of the fabric.

In one embodiment of the present disclosure, the calculated value of Formula 1 indicates the limit of a decrease in tensile strength before and after forming the metal layer by plasma sputtering on one or both surfaces of the fabric. The calculated value of Formula 1 may be 70 or more, 80 or more, 90 or more, or 95 or more. A relatively great calculated value of Formula 1 indicates that the tensile strength did not decrease but the fabric maintains high tension strength. The upper limit of the value is not particularly limited but may be 100%. In this case, the tensile strength refers to an average value of a warp tensile strength value and a weft tensile strength value.

In one example of the present disclosure, the antiviral fabric manufacturing method satisfies Formula 2 shown below.

$$[Formula\ 2]$$

$$(D1-D0)*\ 100\ (\%)\ \geq\ 70$$

In Formula 2,

D1 is the virus killing rate (D1) after the step of forming the metal layer by plasma sputtering on one or both surfaces of the fabric, and

D0 is the virus killing rate (D0) before the step of forming the metal layer by plasma sputtering on one or both surfaces of the fabric.

In one embodiment of the present disclosure, the calculated value of Formula 2 indicates an increase in virus killing rate before and after forming the metal layer by plasma sputtering on one or both surfaces of the fabric. The calculated value of Formula 2 may be 70 or more, 75 or more, 80 or more, or 85 or more. A relatively great calculated value of Formula 2 indicates that the virus killing rate remains high. The upper limit of the value is not particularly limited but may be 100%.

In one example of the present disclosure, the antiviral fabric manufacturing method satisfies Formula 3 shown below.

$$[\text{Formula 3}]$$

$$\{T1/T0 + (D1-D0)\}/2 * 100(\%) \geq 70$$

In Formula 3,

T1 is the tensile strength T1 of the antiviral fabric after forming the metal layer by plasma sputtering on one or both surfaces of the fabric, and

T0 is the tensile strength T0 of the antiviral fabric prior to forming the metal layer by plasma sputtering on one or both surfaces of the fabric.

D1 is the virus killing rate (D1) after the step of forming the metal layer by plasma sputtering on one or both surfaces of the fabric, and

D0 is the virus killing rate (D0) before the step of forming the metal layer by plasma sputtering on one or both surfaces of the fabric.

In one embodiment of the present disclosure, the calculated value of Formula 3 indicates an average value of a decrease in tensile strength and an increase in virus killing rate before and after forming the metal layer by plasma sputtering on one or both surfaces of the fabric. The calculated value of Formula 1 may be 70 or more, 80 or more, 85 or more, or 90 or more. A relatively great calculated value of Formula 3 indicates that the tensile strength does not significantly decrease and the virus killing rate remains high. The upper limit of the value is not particularly limited but may be 100%.

In one embodiment of the present disclosure, the metal layer may comprise: one or more materials selected from the group consisting of indium (In), titanium (Ti), tin (Sn), silicon (Si), germanium (Ge), aluminum (Al), nickel (Ni), vanadium (V), tungsten (W), tantalum (Ta), molybdenum (Mo), neodymium (Nb), iron (Fe), chromium (Cr), cobalt (Co), silver (Ag), copper (Cu), and zinc (Zn), nitrides thereof, and oxides thereof.

In one embodiment of the present disclosure, the metal layer may comprise one or more materials selected from the group consisting of metals comprising silver (Ag), copper (Cu), and zinc (Zn), nitrides thereof; and oxides thereof. The materials are materials that have been confirmed to have a good virus killing effect.

In one embodiment of the present disclosure, the step of forming the metal layer by plasma sputtering on one surface or both surfaces of the fabric may comprise: feeding the fabric into a chamber provided with a target made of the metal described above;

introducing a sputtering gas into the chamber; and

applying a voltage between the fabric and the metal target to generate plasma inside the chamber.

In one embodiment of the present disclosure, the plasma sputtering may be performed using known equipment.

In one embodiment of the present disclosure, the metal target may be a raw material of metal to form the metal layer on the fabric.

In one embodiment of the present disclosure, a vacuum condition may be formed in the chamber before the sputtering gas is introduced into the chamber.

In one embodiment of the present disclosure, the introducing of the sputtering gas into the chamber is to supply the sputtering gas. The sputtering gas may be an inert gas or a reactive gas such as oxygen or nitrogen. When a reactive gas is used, the plasma sputtering may be reactive sputtering.

In one embodiment of the present disclosure, the sputtering gas may be argon (Ar) or helium (He).

In one embodiment of the present disclosure, in the step of generating plasma in the chamber by applying a voltage between the fabric and the metal target, the plasma is generated around the metal target, and cations in a plasma discharge region are accelerated by an electric field generated between the fabric and the metal target so that the accelerated cations collide with the metal target. In turn, metal atoms are emitted from the metal target, and the metal atoms move and reach one surface of the fabric.

In one embodiment of the present disclosure, the distance between the fabric and the metal target may be in a range of 1 cm to 30 cm, a range of 3 cm to 20 cm, or a range of 5 cm to 10 cm. When the range is satisfied, the thickness of the metal layer required by the present disclosure can be easily obtained.

In one embodiment of the present disclosure, the voltage applied per unit area of the target may be in a range of 1 kW to 100 kW, a range of 1 kW to 50 kW, a range of 2 kW to 10 kW, or a range of 3 kW to 8 kW. When the range is satisfied, the thickness of the metal layer required by the present disclosure can be easily obtained.

In one embodiment of the present disclosure, a process pressure required in the step of applying a voltage between the fabric and the metal target to generate plasma in the chamber may be in a range of 1 mTorr to 100 mTorr, preferably a range of 1 mTorr to 75 mTorr, and more preferably a range of 1 mTorr to 50 mTorr. When the process pressure during the sputtering process is higher than the upper limit of the range, the number of plasma gas particles in the chamber increases, and the particles emitted from the target collide with the plasma gas particles and thus lose energy. Therefore, the growth rate of the island may be reduced. On the other hand, when the process pressure is maintained at a low level, the energy loss of the island component particles due to the plasma gas particles is reduced. However, since there is a disadvantage that the fabric may be damaged by the particles having a high energy level, the optimum sputtering process conditions must be obtained by controlling various parameters such as the size of the deposition equipment, the distance between a sample position and the target, the type of the target, the type of gas, the flow rate of gas, and the process pressure.

In one embodiment of the present disclosure, the step of forming a metal layer by plasma sputtering on one surface or both surfaces of the fabric may be performed for a duration in a range of 1 minute to 1 hour, a range of 3 minutes to 30 minutes, or a range of 3 minutes to 25 minutes. When the range is satisfied, the durability of the fabric can be maintained, and the thickness of the metal layer required by the present disclosure can be easily obtained.

In one embodiment of the present disclosure, the pre-processing of the fabric is performed to remove residual contaminants present on the fabric.

In one embodiment of the present disclosure, the pre-processing of the fabric may be a method of dipping a fabric in a pre-processing solution.

In one embodiment of the present disclosure, the pre-processing solution may be one or more solutions selected from the group consisting of ammonium persulfate $(NH_4)_2S_2O_8$, $NH_4HSO_5$, KHSOs, hydrogen peroxide, bromate, and persulfate.

In one embodiment of the present disclosure, the method may further comprise a step of maintaining the fabric under vacuum conditions at a temperature of 25°C for a duration of 1 hour to 10 hours before the step of forming the metal layer by plasma sputtering on one surface or both surfaces of the fabric. The duration may be in a range of 2 hours to 8 hours or a range of 4 hours to 6 hours.

In one embodiment of the present disclosure, the method may further comprise a step cooling the fabric with a cooling fluid having a temperature of 60°C or lower after the step of forming the metal layer by plasma sputtering on one or both surfaces of the fabric. That is, the fabric heated during the sputtering is cooled in the cooling step.

In one embodiment of the present disclosure, the cooling fluid used in the cooling step may have a temperature in a range of 25°C to 60°C or a range of 25°C to 40°C. When the numerical range is satisfied, the cooling rate may be improved.

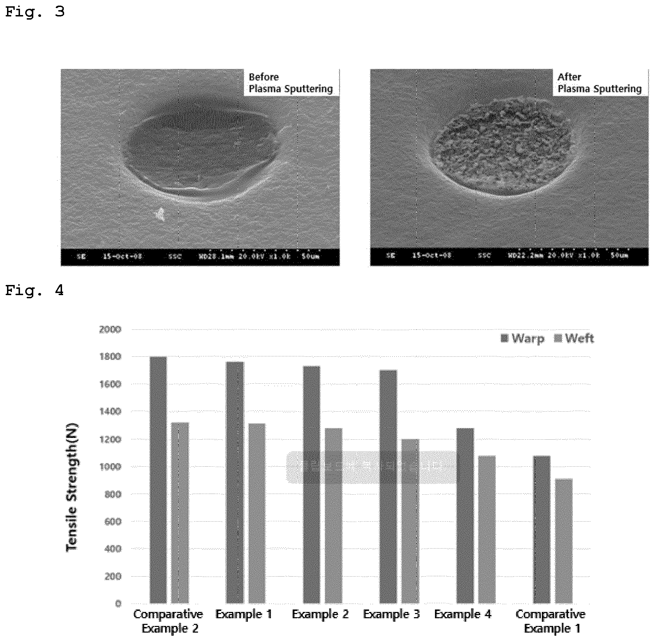

In one embodiment of the present disclosure, the step of forming the metal layer by plasma sputtering on one or both surfaces of the fabric may comprise a step of etching one or both surfaces of the fabric. The plasma sputtering causes the surface of the fabric to be etched, thereby changing the morphology of the surface of the fabric. Specifically, since the surface area of the fabric is increased, the surface area on which the metal atoms are deposited is increased. Photographs taken before and after plasma sputtering are shown in FIG. 3.

One embodiment of the present disclosure provides an antiviral fabric manufactured by the method described above, and the antiviral fabric comprises a fabric and a metal layer having a thickness of 5 nm to 900 nm and being formed on one surface or both surfaces of the fabric.

**Mode For Invention**

Hereinafter, the present disclosure will be described with reference to examples.

**Example 1**

A polyethylene terephthalate (PET) fabric was prepared. A plasma sputtering process was performed for 5 minutes at a power of 5 kW on one surface of the fabric, so that a copper (Cu) layer with a thickness of 10 nm was formed, resulting in an antiviral fabric.

**Example 2**

A polyethylene terephthalate (PET) fabric was prepared. An antiviral fabric was prepared in the same manner as in Example 1, except that the copper (Cu) layer was formed to have a thickness of 10 nm by performing plasma sputtering at a power of 5 kW for 10 minutes.

**Example 3**

A polyethylene terephthalate (PET) fabric was prepared. An antiviral fabric was prepared in the same manner as in Example 1, except that a plasma sputtering process was performed for 15 minutes at a power of 5 kW on one surface of the fabric, and the copper (Cu) layer was formed to have a thickness of 10 nm.

**Example 4**

A polyethylene terephthalate (PET) fabric was prepared. An antiviral fabric was prepared in the same manner as in Example 1, except that the copper (Cu) layer was formed to have a thickness of 500 nm by performing plasma sputtering at a power of 5 kW for 20 minutes.

**Comparative Example 1**

A polyethylene terephthalate (PET) fabric was prepared. An antiviral fabric was prepared in the same manner as in Example 1, except that a plasma sputtering process was performed for 30 minutes at a power of 5 kW on one surface of the fabric, and the copper (Cu) layer was formed to have a thickness of 1,000 nm.

**Comparative Example 2**

A polyethylene terephthalate (PET) fabric with no metal layer was prepared.

**Experimental Example 1: Analysis of physical properties of fabric**

The tensile strength of each of the fabrics of the examples and the comparative examples was measured. In the measuring, a universal material test machine (model: ZOOS, manufactured by Zwickroell, Germany) was used. According to ISO 13934-1, a fiber fabric with a size of 100 cm x 100 cm or larger was prepared, and 5 specimens, each with a size of 25 cm x 5 cm, were taken from the fiber fabric. The specimens were taken at positions distanced by 5 cm or more from the edge of the fiber fabric. The gauge length of the test machine was set to 200 mm, and the test speed was set to 200 mm/min. The final result value was the average value of the measurement values of the five specimens. The values are shown in FIG. 4.

**Experiment Example 2: Testing of viral death characteristics**

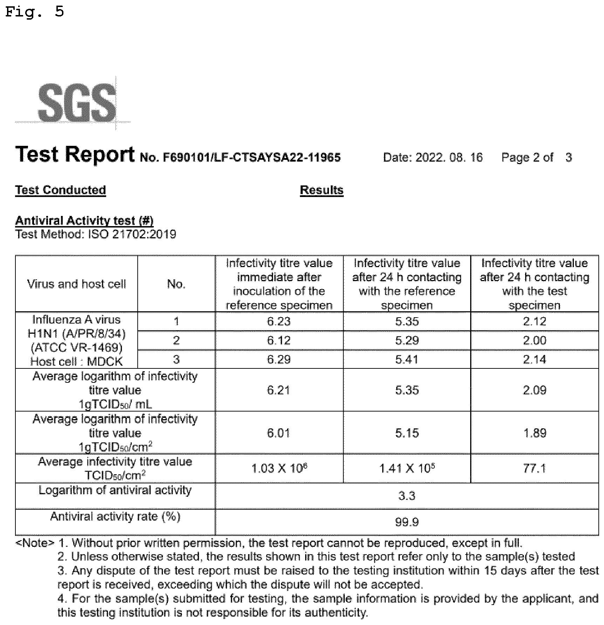

The death characteristics of the virus "Influenza A virus" were tested. The viruses were brought into contact with the antiviral fabrics manufactured according to the examples and comparative examples for 24 hours, and the number of viruses surviving before and after the contact was compared, and the virus killing rate (%) was determined. FIG. 5 is a test report for the antiviral fabric of Example 4.

**Experimental Example 3: Characteristic comparison between fabrics**

On the basis of the obtained test results, the values of Formulas 1 to 3 were calculated. The description of the formulas are given above.

[Table 1]

| Classification | | Example 1 | Example 2 | Example 3 | Example 4 | Comparati ve Example 1 | Comparati ve Example 2 |
|---|---|---|---|---|---|---|---|
| Copper thickness (nm) | | 10 | 50 | 100 | 500 | 1000 | 0 |
| Experimen tal Example 1 | Warp (N) | 1,761 | 1730 | 1709 | 1281 | 1082 | 1803 |
| | Weft (N) | 1,311 | 1284 | 1202 | 1079 | 909 | 1321 |
| | Average value | 1, 536 | 1507 | 1455 | 1180 | 995 | 1562 |
| Experimental Example 2 | | 88.3% | 94.2% | 97.7% | 99.9% | 99.9% | 0% |
| Experimen tal Example 3 | [Formula 1] | 98.3 | 96.5 | 93.2 | 75.5 | 63.7 | 100 |
| | [Formula 2] | 88.3 | 94.2 | 97.7 | 99.9 | 99.9 | 0 |
| | [Formula 3] | 93.3 | 95.3 | 95.4 | 87.7 | 81.8 | 50 |
| | | | | | | | |

From the above results, it was confirmed that the fabric provided with no metal layer had no virus killing function (Comparative Example 2), and the fabric with a metal layer having a thickness exceeding 900 nm showed deterioration in physical properties (Comparative Example 1). When the fabric has a thickness of 900 nm or smaller, the value calculated by Formula 1 was 70% or greater which indicates the physical properties being not significantly deteriorated, and the value calculated by Formula 2 was 70% or greater which indicate excellent virus killing function.

In addition, the value calculated by Formula 3 was 70% or greater which indicates that the fabric has good physical properties and an antiviral function.

## Claims

1.  A method of manufacturing an antiviral fabric, the method comprising:

    pre-processing a fabric; and
    forming a metal layer, by plasma sputtering, on one surface or both surfaces of the fabric,
    wherein the metal layer has a thickness in a range of 5 nm to 900 nm.

2.  The method of claim 1, satisfying Formula 1:

    [Formula 1]

    $$T1/TO * 100\ (\%)\ \geq\ 70$$

    In Formula 1,

    T1 is the tensile strength T1 of the antiviral fabric after forming the metal layer by plasma sputtering on one or both surfaces of the fabric, and
    T0 is the tensile strength T0 of the antiviral fabric prior to forming the metal layer by plasma sputtering on one or both surfaces of the fabric.

3.  The method of claim 1, satisfying Formula 2:

[Formula 2]

$$(D1-D0) * 100 (\%) \geq 70$$

In Formula 2,

D1 is the virus killing rate (D1) after the step of forming the metal layer by plasma sputtering on one or both surfaces of the fabric, and
D0 is the virus killing rate (D0) before the step of forming the metal layer by plasma sputtering on one or both surfaces of the fabric.

4. The method of claim 1, satisfying Formula 3:

[Formula 3]

$$\{T1/T0 + (D1-D0)\}/2 * 100(\%) \geq 70$$

In Formula 3,

T1 is the tensile strength T1 of the antiviral fabric after forming the metal layer by plasma sputtering on one or both surfaces of the fabric, and
T0 is the tensile strength T0 of the antiviral fabric prior to forming the metal layer by plasma sputtering on one or both surfaces of the fabric.
D1 is the virus killing rate (D1) after the step of forming the metal layer by plasma sputtering on one or both surfaces of the fabric, and
D0 is the virus killing rate (D0) before the step of forming the metal layer by plasma sputtering on one or both surfaces of the fabric.

5. The method of claim 1, wherein the metal layer comprises one or more materials selected from the group consisting of indium (In), titanium (Ti), tin (Sn), silicon (Si), germanium (Ge), aluminum (Al), nickel (Ni), vanadium (V), tungsten (W), tantalum (Ta), molybdenum (Mo), neodymium (Nb), iron (Fe), chromium (Cr), cobalt (Co), silver (Ag), copper (Cu), and zinc (Zn), nitrides thereof, and oxides thereof.

6. The method of claim 1, the forming of the metal layer by plasma sputtering on one surface or both surfaces of the fabric comprises:

feeding the fabric into a chamber equipped with a metal target;
introducing a sputtering gas into the chamber; and
applying a voltage between the fabric and the metal target to generate a plasma inside the chamber.

7. The method of claim 6, wherein a distance between the fabric and the metal target is in a range of 1 cm to 30 cm.

8. The method of claim 6, wherein the voltage applied to the target, per unit area of the target, is in a range of 1 kW and 100 kW.

9. The method of claim 6, wherein during the applying of the voltage between the fabric and the metal target to generate plasma inside the chamber, a process pressure may be set to be in a range of 1 mTorr to 100 mTorr.

10. The method of claim 6, wherein the sputtering gas is argon (Ar) or helium (He).

11. The method of claim 1, wherein the forming of the metal layer by plasma sputtering on one surface of the fabric or on both surfaces of the fabric is performed for a period of 1 minute to 1 hour.

12. The method of claim 1, further comprising maintaining the fabric under vacuum conditions at a temperature of 25°C for a duration of 1 hour to 10 hours before the forming of the metal layer by plasma sputtering on one surface or both surfaces of the fabric.

13. The method of claim 1, further comprising cooling the fabric with a cooling fluid having a temperature of 60°C or lower after the forming of the metal layer by plasma sputtering on one or both surfaces of the fabric.

14. The method of claim 1, wherein the forming of the metal layer by plasma sputtering on one surface or both surfaces of the fabric comprises etching the one surface or both surfaces of the fabric.

15. An antiviral fabric manufactured by the method of any one of claims 1 to 14, the antiviral fabric comprising:

a fabric; and
a metal layer having a thickness in a range of 5 nm to 900 nm and being provided on one surface or both surfaces of the fabric.

Fig. 1

Fig. 2

Fig. 3

Fig. 4

Fig. 5

**SGS**

**Test Report** No. F690101/LF-CTSAYSA22-11965        Date: 2022. 08. 16    Page 2 of  3

**Test Conducted**                                    **Results**

**Antiviral Activity test (#)**
Test Method: ISO 21702:2019

| Virus and host cell | No. | Infectivity titre value immediate after inoculation of the reference specimen | Infectivity titre value after 24 h contacting with the reference specimen | Infectivity titre value after 24 h contacting with the test specimen |
|---|---|---|---|---|
| Influenza A virus H1N1 (A/PR/8/34) (ATCC VR-1469) Host cell : MDCK | 1 | 6.23 | 5.35 | 2.12 |
| | 2 | 6.12 | 5.29 | 2.00 |
| | 3 | 6.29 | 5.41 | 2.14 |
| Average logarithm of infectivity titre value $1gTCID_{50}/ mL$ | | 6.21 | 5.35 | 2.09 |
| Average logarithm of infectivity titre value $1gTCID_{50}/cm^2$ | | 6.01 | 5.15 | 1.89 |
| Average infectivity titre value $TCID_{50}/cm^2$ | | $1.03 \times 10^6$ | $1.41 \times 10^5$ | 77.1 |
| Logarithm of antiviral activity | | 3.3 | | |
| Antiviral activity rate (%) | | 99.9 | | |

<Note> 1. Without prior written permission, the test report cannot be reproduced, except in full.
2. Unless otherwise stated, the results shown in this test report refer only to the sample(s) tested
3. Any dispute of the test report must be raised to the testing institution within 15 days after the test report is received, exceeding which the dispute will not be accepted.
4. For the sample(s) submitted for testing, the sample information is provided by the applicant, and this testing institution is not responsible for its authenticity.

## INTERNATIONAL SEARCH REPORT

| International application No. |
|---|
| **PCT/KR2022/014752** |

**A. CLASSIFICATION OF SUBJECT MATTER**

**D06M 11/83**(2006.01)i; **C23C 14/34**(2006.01)i

According to International Patent Classification (IPC) or to both national classification and IPC

**B. FIELDS SEARCHED**

Minimum documentation searched (classification system followed by classification symbols)

D06M 11/83(2006.01); C09D 7/20(2018.01); C09D 7/61(2018.01); C23C 14/22(2006.01); C23C 14/34(2006.01); D06M 10/00(2006.01); D06M 11/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전처리(pretreatment), 금속(metal), 플라즈마(plasma), 스퍼터링(sputtering), 항바이러스(antivirus), 원단(fabric)

**C. DOCUMENTS CONSIDERED TO BE RELEVANT**

| Category* | Citation of document, with indication, where appropriate, of the relevant passages | Relevant to claim No. |
|---|---|---|
| X | CN 104831528 A (JIAXING ZHONGKE AODU NEW MATERIAL CO., LTD.) 12 August 2015 (2015-08-12)<br>See abstract; claims 1-4; and paragraph [0015]. | 1,5-6,10,15 |
| Y | | 7-9,11,14 |
| A | | 2-4,12-13 |
| Y | CN 101275361 A (SUZHOU INDUSTRY PARK ZONE HONGJIN NANOMETER CO., LTD.) 01 October 2008 (2008-10-01)<br>See claims 1-2; and example 1. | 7-9,11 |
| Y | KR 10-0591363 B1 (CH TECH. INC. et al.) 21 June 2006 (2006-06-21)<br>See abstract; and paragraphs [0002]-[0041]. | 14 |
| A | KR 10-2174307 B1 (EVERCOAT et al.) 04 November 2020 (2020-11-04)<br>See entire document. | 1-15 |

☑ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **16 June 2023** | **20 June 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
|---|
| **PCT/KR2022/014752** |

**C.     DOCUMENTS CONSIDERED TO BE RELEVANT**

| Category* | Citation of document, with indication, where appropriate, of the relevant passages | Relevant to claim No. |
|---|---|---|
| A | KR 10-2308519 B1 (NEONANOMEDICSKOREA CO., LTD. et al.) 05 October 2021 (2021-10-05)<br>See entire document. | 1-15 |

Form PCT/ISA/210 (second sheet) (July 2022)

**INTERNATIONAL SEARCH REPORT**
Information on patent family members

International application No.

**PCT/KR2022/014752**

| Patent document cited in search report | | | Publication date (day/month/year) | Patent family member(s) | | | Publication date (day/month/year) |
|---|---|---|---|---|---|---|---|
| CN | 104831528 | A | 12 August 2015 | CN | 104831528 | B | 13 October 2017 |
| CN | 101275361 | A | 01 October 2008 | None | | | |
| KR | 10-0591363 | B1 | 21 June 2006 | None | | | |
| KR | 10-2174307 | B1 | 04 November 2020 | KR 10-2020-0120176 | | A | 21 October 2020 |
| KR | 10-2308519 | B1 | 05 October 2021 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020220122664

- KR 101724038 B1